(19) **Europäisches Patentamt / European Patent Office / Office européen des brevets**

(11) **EP 1 223 585 B1**

(12) **FASCICULE DE BREVET EUROPEEN**

(45) Date de publication et mention
de la délivrance du brevet:
**16.04.2008 Bulletin 2008/16**

(51) Int Cl.:
*G11C 11/16* (2006.01)  *H01F 10/32* (2006.01)

(21) Numéro de dépôt: **01403132.2**

(22) Date de dépôt: **05.12.2001**

(54) **Dispositif magnétique à polarisation de spin et à empilement(s) tri-couche(s) et mémoire utilisant ce dispositif**

Spin polarisierte magnetische dreischichtige Stapelanordnung und Speicher unter Verwendung einer solchen

Tri-layer stack spin polarised magnetic device and memory using the same

(84) Etats contractants désignés:
**DE GB IT**

(30) Priorité: **07.12.2000 FR 0015895**

(43) Date de publication de la demande:
**17.07.2002 Bulletin 2002/29**

(73) Titulaire: **COMMISSARIAT A L'ENERGIE ATOMIQUE**
**75015 Paris (FR)**

(72) Inventeurs:
• **Redon, Olivier**
**38170 Seyssinet (FR)**
• **Dieny, Bernard**
**38250 Lans-en-Vercors (FR)**
• **Rodmacq, Bernard**
**38113 Veurey-Voroize (FR)**

(74) Mandataire: **Poulin, Gérard et al**
**Société BREVATOME**
**3, rue du Docteur Lancereaux**
**75008 Paris (FR)**

(56) Documents cités:
EP-A- 1 096 500     EP-A- 1 187 103
US-A- 5 541 868     US-A- 5 661 062
US-A- 5 966 323

# Description

## Domaine technique

La présente invention a pour objet un dispositif magnétique à polarisation de spin et à empilement(s) tri-couche(s) et une mémoire utilisant ce dispositif.

Elle trouve une application en électronique et notamment dans la réalisation de points mémoire et de mémoire de type MRAM ("Magnetic Random Access Memory" ou mémoire magnétique à accès direct (ou aléatoire)).

## Etat de la technique antérieure

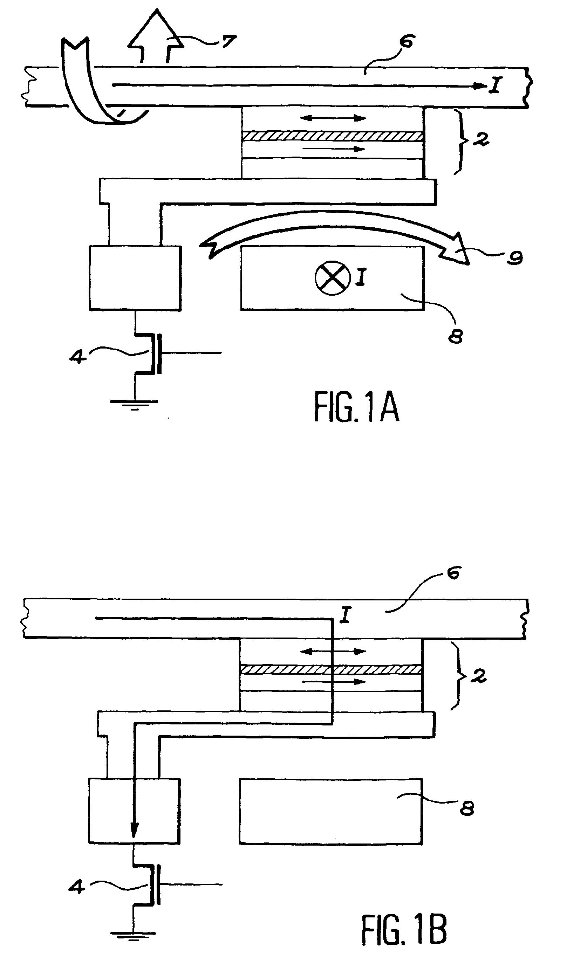

Les mémoires magnétiques MRAM ont connu un regain d'intérêt avec la mise au point de jonctions tunnel magnétiques (en abrégé MTJ pour "Magnetic Tunnel Junction") présentant une forte magnétorésistance à température ambiante. Les figures 1A et 1B annexées illustrent schématiquement la structure et la fonction d'une telle jonction.

La jonction porte la référence 2. Il s'agit d'un empilement comprenant une couche d'oxyde en sandwich entre deux couches magnétiques. Ce système fonctionne comme une vanne de spin, à la différence que le courant circule perpendiculairement aux plans des couches. L'une des couches magnétiques est dite "libre" car son aimantation peut s'orienter dans un champ magnétique extérieur (flèche bidirectionnelle) ; l'autre est dite "piégée" car sa direction d'aimantation est fixée par une couche d'échange antiferromagnétique (flèche unidirectionnelle). Lorsque les aimantations des couches magnétiques sont antiparallèles, la résistance de la jonction est élevée ; lorsque les aimantations sont parallèles, la résistance devient faible. La variation relative de résistance entre ces deux états peut atteindre 40% par un choix approprié des matériaux.

La jonction 2 est placée entre un transistor de commutation 4 et une ligne d'amenée de courant 6. Un courant passant dans celle-ci produit un champ magnétique 7. Un conducteur 8, orthogonal à la ligne d'amenée de courant 6 (c'est-à-dire en l'espèce, perpendiculaire au plan de la figure) permet de produire un second champ magnétique 9 (situé dans le plan de la figure).

Dans le mode "écriture" (Fig. 1A), le transistor 4 est bloqué. Des courants circulent dans l'amenée de courant 6 et dans le conducteur 8. La jonction 2 est donc soumise à deux champs magnétiques orthogonaux. L'un est appliqué selon l'axe de difficile aimantation de la couche libre, afin de réduire son champ de retournement, l'autre étant appliqué selon son axe facile afin de provoquer le retournement de l'aimantation et l'écriture du point mémoire. Dans le principe, seul le point mémoire placé à l'intersection des deux lignes 6 et 8 est susceptible de se retourner, car chaque champ magnétique pris individuellement n'est pas suffisamment grand pour provoquer un basculement de l'aimantation.

Dans le mode "lecture" (Fig. 1B), le transistor est placé en régime saturé (c'est-à-dire que le courant le traversant est maximum) par l'envoi d'une impulsion de courant positive dans la base. Le courant envoyé dans la ligne 6 traverse uniquement le point mémoire dont le transistor est ouvert. Ce courant permet de mesurer la résistance de la jonction. Par comparaison avec un point mémoire de référence, l'état du point mémoire ("O" ou "1") peut ainsi être déterminé.

Un tel mécanisme d'écriture présente des inconvénients en particulier dans un réseau de jonctions :

1) Comme le renversement de l'aimantation de la couche libre d'une jonction se produit sous l'effet de champs extérieurs, et comme les champs de retournement sont statistiquement distribués, il n'est pas impossible de retourner accidentellement certaines jonctions voisines simplement par l'effet du champ magnétique produit le long de la ligne d'adressage 6. Comme, pour des mémoires à haute densité, la taille des points mémoires est nettement submicronique, le nombre d'erreurs d'adressage augmente.

2) La diminution de la taille des points mémoires entraîne une augmentation de la valeur du champ de retournement individuel ; un courant plus important est alors nécessaire pour écrire les points mémoires, ce qui tend à augmenter la consommation électrique.

3) L'écriture nécessitant deux lignes de courant à 90°, la densité d'intégration se trouve limitée par la présence de ces lignes.

4) Le mode d'écriture utilisé ne permet d'écrire qu'un seul point mémoire à la fois, si l'on veut minimiser le risque d'erreur d'adressage.

Récemment sont apparus d'autres types de dispositifs magnétiques où le reversement de l'aimantation se produit non plus par des champs magnétiques extérieurs mais par des électrons traversant l'empilement perpendiculairement au plan des couches. Ces dispositifs sont décrits dans le document US-A-5,695,864. Le mécanisme mis en oeuvre est fondé sur un transfert de moment magnétique entre les électrons d'une part et l'aimantation de la couche libre, d'autre part. Dans un tel système, l'empilement est formé de couches toutes conductrices de l'électricité, afin de limiter la puissance dissipée. Il en résulte plusieurs inconvénients :

a) la résistance du dispositif est si faible qu'il faut injecter un courant très intense pour avoir une tension aux bornes comparable à celle des systèmes anciens,

b) une telle intensité nécessite un transistor de grande taille, ce qui limite la densité d'intégration de la mémoire,

c) l'amplitude de la variation de résistance obtenue est très faible (2-3%), ce qui limite la tension de sortie,

d) dans l'application aux MRAM, le document cité prévoit trois niveaux de conducteurs et deux sources de tension. Un conducteur central a pour but de récupérer le courant polarisé ayant servi au retournement de la couche libre. Le dispositif est donc complexe.

La présente invention a justement pour but de remédier à ces inconvénients.

US-A-5 966 323 décrit une jonction tunnel magnétorésistive à faible champ de commutation pour réseaux à haute densité. EP-A-1 187 103 décrit un dispositif à effet magnétorésistif et une mémoire utilisant ce dispositif.

## Exposé de l'invention

L'invention vise à réduire la densité critique de courant à partir de laquelle le retournement de l'aimantation se produit dans la couche libre. Les travaux et réflexions du Demandeur ont permis de comprendre que cette densité critique était liée au champ démagnétisant propre à la couche libre. L'invention propose alors un dispositif dans lequel ce champ démagnétisant est très faible, voire nul. Pour cela, on utilise un empilement à trois couches (que l'on appellera par la suite "empilement tri-couche" ou simplement "tri-couche") formé de deux couches magnétiques séparées par une couche conductrice non magnétique, cette dernière ayant une épaisseur suffisamment faible pour que le couplage entre les deux couches magnétiques soit suffisamment fort pour que les aimantations dans ces couches soient antiparallèles. Globalement, un tel système ne présente pas (ou peu) de champ démagnétisant. Le Demandeur qualifie de tels empilements de "synthétiques".

De façon précise, l'invention a donc pour objet un dispositif magnétique conforme à la revendication 1.

Dans un mode de réalisation, la couche piégée est, elle aussi constituée d'un empilement tri-couche, ce deuxième empilement étant recouvert d'une couche d'échange antiferromagnétique fixant la direction des aimantations dans ledit deuxième empilement tri-couche.

Dans un autre mode de réalisation, le dispositif comprend un troisième empilement tri-couche séparé du premier par une couche conductrice non magnétique, ce troisième empilement tri-couche reposant sur une seconde couche d'échange antiferromagnétique fixant les aimantations dans ce troisième tri-couche.

Le matériau des couches magnétiques du premier et/ou du deuxième et/ou du troisième empilement tricouche est de préférence en un matériau pris dans le groupe constitué par Co, Fe, Ni et leurs alliages.

La couche conductrice non magnétique du premier et/ou du deuxième et/ou du troisième empilement tricouche est de préférence en un métal pris dans le groupe constitué par Ru, Re, Cu, Cr, Pt, Ag.

La première et/ou la seconde couche antiferromagnétique peut être en alliage à base de Mn (par exemple FeMn, IrMn, NiMn, PtMn, PtPdMn, RuRhMn).

## Brève description des dessins

- les figures 1A et 1B, déjà décrites, montrent un dispositif connu pour l'écriture et la lecture d'une information binaire dans une jonction magnétique à effet tunnel par des champs magnétiques extérieurs ;
- la figure 2 montre, en coupe, un premier mode de réalisation d'un dispositif selon l'invention ;
- les figures 3A et 3B montrent les orientations des aimantations dans les différentes couches selon qu'on a écrit un "0" ou un "1" pour ce premier mode de réalisation ;
- les figures 4A et 4B montrent les variations transitoires de la composante de l'aimantation selon un axe Oz perpendiculaire au plan des couches et selon un axe Oy parallèle au plan des couches, pour une faible et une forte anisotropie ;
- la figure 5 montre, en coupe, un second mode de réalisation d'un dispositif selon l'invention ;
- les figures 6A et 6B montrent les orientations des aimantations dans les différentes couches selon qu'on a écrit un "O" ou un "1", pour ce second mode de réalisation ;
- la figure 7 montre schématiquement une mémoire utilisant une matrice de dispositifs selon l'invention.

## Description de modes particuliers de réalisation

A propos du phénomène de polarisation de spin pour des électrons circulant dans des dispositifs à jonction tunnel, on peut rappeler les principes suivants. Un courant électrique circulant dans un conducteur est constitué d'électrons dont le spin n'a aucune raison a priori d'être orienté dans une direction particulière. Lorsque ce courant traverse une couche magnétique présentant une aimantation particulière, les spins vont se trouver orientés par des phénomènes d'échange de moment magnétique, de sorte que les électrons sortiront de cette couche avec un spin polarisé. Une telle couche (ou un ensemble de telles couches) constitue ainsi un "polariseur". Ce phénomène peut jouer aussi bien en transmission (à travers la couche) qu'en réflexion (sur cette couche), selon la direction de circulation du courant. Il peut également jouer en sens inverse en laissant passer de préférence des électrons ayant un spin polarisé dans une certaine direction. La fonction de la couche est alors celle d'un analyseur.

S'agissant maintenant du premier mode de réalisation de l'invention, il consiste à utiliser une jonction tunnel formée de deux empilements tri-couches disposés de part et d'autre d'une couche isolante, par exemple en alumine ($Al_2O_3$). Un des tri-couches a sa direction d'aimantation fixée par couplage d'échange avec une couche antiferromagnétique. Cette couche joue un double rôle de polariseur (à l'écriture) et d'analyseur (à l'écriture et la lecture). Le choix d'un tri-couche a été retenu pour éliminer le couplage magnétostatique avec le second tri-couche et donc pour pouvoir utiliser la mémoire sans champ extérieur de compensation. L'autre tri-couche est libre de s'orienter dans la direction de polarisation des spins.. Cette couche possède une anisotropie planaire définissant un axe de facile et un axe de difficile aimantation afin de réduire le temps d'écriture. Les épaisseurs des couches magnétiques de ce système tri-couche sont quasiment égales afin d'éliminer l'effet de champ démagnétisant et donc permettre l'aimantation de cette couche de précessionner facilement hors du plan.

Dans le mode écriture, un courant de densité supérieure à la densité critique traversant la jonction va provoquer une précession et un alignement de l'aimantation de la couche libre (la plus proche de la barrière d'oxyde) par transfert du moment magnétique des électrons polarisés au moment magnétique de la couche libre. La tension apparaissant aux bornes de la jonction, permet de suivre l'état magnétique de la couche libre. L'écriture peut se faire en courant continu ou en courant pulsé, la durée de l'impulsion devant être ajustée en fonction du processus de retournement de l'aimantation.

Dans le mode lecture, un courant de densité inférieure à la densité critique traverse la jonction et permet de lire l'état magnétique du dispositif, lequel se comporte ainsi comme un point mémoire.

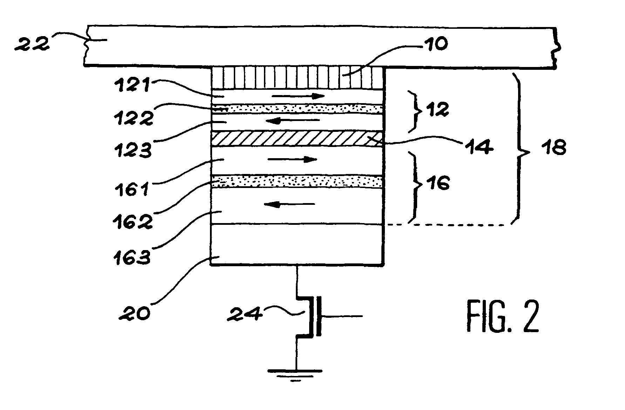

La figure 2 illustre ce premier mode de réalisation. Tel que représenté, le dispositif comprend deux empilements tri-couches (ou "synthétiques"), respectivement 12 et 16, l'un pour la couche piégée (12) et l'autre pour la couche libre (16). Dans la variante illustrée, le dispositif comprend successivement, de haut en bas, une couche d'échange antiferromagnétique 10, la couche piégée 12, une couche isolante non magnétique 14, la couche libre 16, l'ensemble référencé 18 formant une jonction tunnel magnétique. Cette jonction repose sur un substrat conducteur 20 et se trouve intercalé entre un conducteur 22 et un transistor 24.

Selon le mode de réalisation illustré, la couche piégée 12 est un tri-couche composé de deux couches magnétiques 121, 123 séparées par une couche conductrice non magnétique 122. De même, la couche libre 16 est un tri-couche composé de deux couches magnétiques 161, 163 séparées par une couche conductrice non magnétique 162.

Dans les deux tri-couches 12 et 16, les aimantations des deux couches magnétiques sont antiparallèles, comme représenté symboliquement sur la figure par les flèches de directions alternées, flèches qui représentent l'aimantation. Cet antiparallélisme est dû à un couplage antiferromagnétique très fort existant entre les couches magnétiques. Les épaisseurs des couches magnétiques 121, 123 sont avantageusement les mêmes afin d'avoir un couplage magnétostatique nul sur la couche libre 16.

La couche libre 16 a des caractéristiques similaires à la couche piégée 12. Cependant, n'étant pas piégée par échange, elle est libre, et voit la direction de son aimantation changer lorsqu'un courant polarisé en spin la traverse. Ce changement est lié au transfert de moment magnétique des électrons vers l'aimantation de la couche.

La barrière 14 est formée préférentiellement d'une couche d'aluminium oxydée ou nitrurée, et elle est obtenue par des méthodes connues de l'homme de l'art (oxydation par plasma, oxydation naturelle in situ, source d'oxygène atomique, ...). Des matériaux semi-conducteurs peuvent aussi être employés mais les propriétés magnétorésistives ne sont pas aussi bonnes qu'avec les nitrures et oxydes.

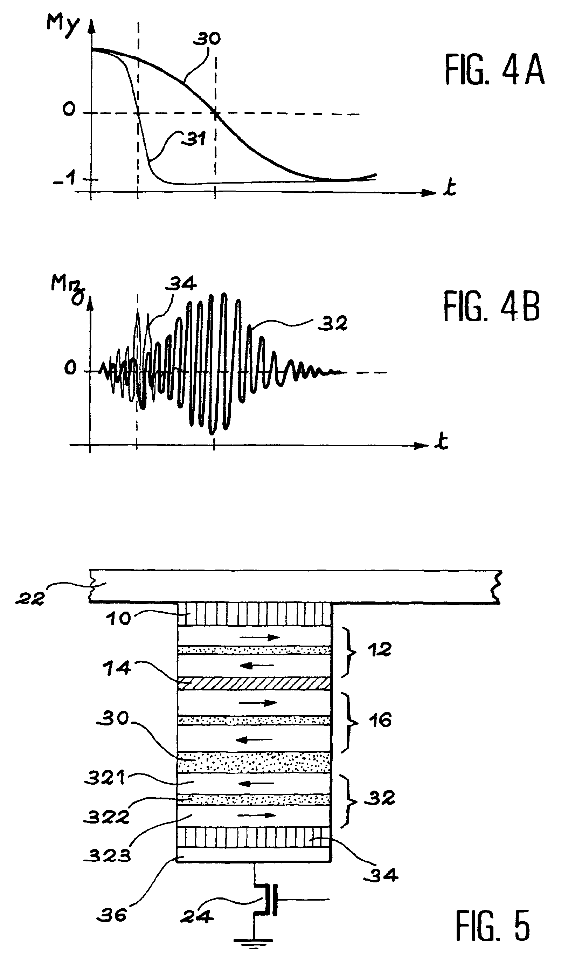

La figure 3A permet d'illustrer l'écriture d'un "O" et la figure 3B l'écriture d'un "1". Sur ces figures, on n'a pas représenté l'amenée de courant ni le transistor. Les différentes directions sont repérées par rapport à un trièdre trirectangle Oxyz, la direction Oz étant perpendiculaire au plan des couches. Par ailleurs, la figure 4A montre comment la composante My de l'aimantation de la couche 161 change de signe et la figure 4B montre l'oscillation de la composante Mz lors du mouvement de précession qui accompagne le renversement de l'aimantation.

Pour écrire un "0", on fait circuler dans l'empilement un courant (continu ou pulsé) de signe positif, c'est-à-dire circulant de haut en bas (donc vers le transistor). Les électrons voient leur spin polarisé dans la couche 123 selon la direction (-y). Ils vont transmettre leur moment magnétique aux moments de la couche 161 dont l'aimantation va s'aligner parallèlement à celle de la couche 123. La couche 163, couplée antiparallèlement à la couche 161, va donc aussi se réorienter. Lors du transfert de moment magnétique, l'aimantation de la couche 161 va entrer en précession autour de l'axe (-y) avec une composante Mz qui va osciller au cours du temps, comme le montre la figure 4B. Lorsque l'angle du cône de précession dépassera 90°, le sens de rotation s'inversera et l'aimantation se réalignera selon (+y). Le nombre de précessions nécessaire au retournement dépend de l'anisotropie de la couche dans son plan. Lorsque l'anisotropie est faible (courbes 30 et 32), le retournement demande un grand nombre d'oscillations de précessions mais un faible courant critique. Pour une plus forte anisotropie (courbes 31 et 34) le temps de retournement est plus court mais un courant plus fort est nécessaire pour vaincre l'anisotropie.

Comme dit précédemment, l'écriture peut se faire en courant continu ou pulsé. Dans le cas d'un courant pulsé, la durée de l'impulsion doit être suffisamment longue pour que le retournement soit complet. Le contrôle du retournement peut s'effectuer par la mesure de la tension aux bornes de la jonction. Lorsque les aimantations des couches 123 et 161 sont parallèles, la probabilité de transfert des électrons par effet tunnel est grande et la résistance de la jonction est faible. Si le retournement ne s'est pas effectué complètement, la résistance est grande. Par comparaison avec la tension prise aux bornes d'une jonction de référence, on détermine l'état magnétique du dispositif. Dans cette étape de contrôle de l'état magnétique, la couche 123 (fixée par échange) joue le rôle d'analyseur pour sonder l'orientation de la couche libre 161.

Pour écrire un "1", on fait circuler un courant de signe négatif comme le montre la figure 3B. En partant de l'état "0", les électrons majoritaires polarisés dans la couche 161 selon (-y) vont traverser la couche 123, alors que les électrons minoritaires polarisés selon (+y) vont s'accumuler devant la couche 123. Ces électrons de spins antiparallèles à la couche 161 vont transférer leur moment magnétique aux moments de la couche 41 et provoquer une précession jusqu'au retournement de l'aimantation de la couche 161 comme montré sur la figure 3B. Cette configuration magnétique correspond à l'écriture d'un "1" et la résistance de la jonction est maximum.

Pour la lecture, on envoie un courant dont la densité est inférieure à la densité critique et on compare la tension de sortie à la tension d'une jonction de référence, afin de déterminer l'état magnétique du dispositif.

Dans un second mode de réalisation, le dispositif comprend trois tri-couches, deux des tri-couches étant disposés de part et d'autre d'une couche isolante, par exemple en alumine ($Al_2O_3$). L'un de ces tri-couches a ses directions d'aimantation fixées par couplage d'échange avec une couche antiferromagnétique. Cette couche joue un double rôle de polariseur (à l'écriture) et d'analyseur (à l'écriture et la lecture). Le choix d'un tri-couche permet d'éliminer le couplage magnétostatique sur le second tri-couche et donc de pouvoir utiliser la mémoire sans champ extérieur de compensation. L'autre tri-couche est libre de s'orienter dans la direction de polarisation des spins. Cette couche peut posséder une anisotropie planaire définissant un axe de facile et un axe de difficile aimantation afin de réduire le temps d'écriture. Les épaisseurs des couches magnétiques de ce système sont quasiment égales afin d'éliminer l'effet de champ démagnétisant. Le dispositif comprend encore un polariseur séparé de la jonction tunnel par une couche conductrice non magnétique et formé préférentiellement d'un empilement tri-couche piégé par échange avec une couche antiferromagnétique afin de maintenir sa direction d'aimantation.

La figure 5 illustre ce second mode de réalisation. Les trois tri-couches portent respectivement les références 16, 12 et 32. Le troisième tri-couche 32 est séparé du premier 16 par une couche conductrice non magnétique 30. Ce troisième tri-couche comprend deux couches magnétiques 321, 323 séparées par une couche conductrice non magnétique 322. Il repose sur une couche de couplage antiferromagnétique 34 qui fixe l'aimantation dans la couche 323, donc dans la couche 321. Le troisième tri-couche 32 est donc du type piégé, comme le deuxième (12). L'ensemble repose sur un substrat conducteur 36.

La couche 30 séparant le premier et le troisième tri-couches peut être formée à partir d'un métal noble. Son épaisseur est choisie entre 3 et 10 nm pour éviter des couplages magnétiques intempestifs entre les tri-couches 16 et 32.

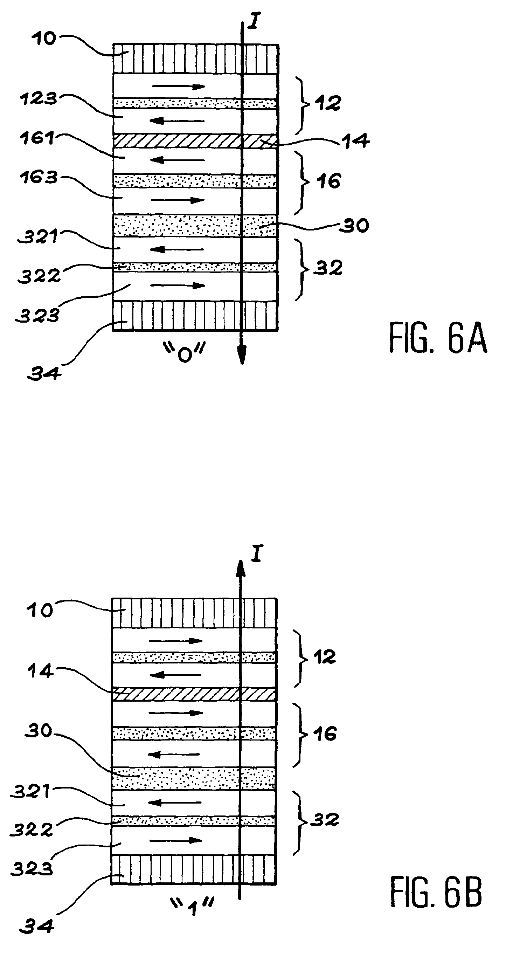

L'écriture des états magnétiques "1" et "0" s'effectue, comme précédemment, par le choix de l'orientation du sens du courant comme le montrent les figures 6A et 6B. L'ajout du troisième tri-couche 32 va stabiliser les états magnétiques et permettre ainsi de réduire la densité de courant critique d'un facteur 2. Dans le cas de l'écriture d'un "0" (figure 6A), le courant polarisé dans la courbe 123 selon (-y) (par rapport à un même trièdre trirectangle Oxyz non représenté) va provoquer l'alignement de la couche 161 par transfert du moment des électrons vers l'aimantation de la couche 161. En sortie de la couche 161, les électrons sont toujours polarisés selon (-y) et se polarisent selon (+y) après passage dans la couche 163, sans provoquer de basculement de la couche 163 à cause de l'échange antiferromagnétique entre les couches 161 et 163 qui est très supérieur au couplage exercé par les électrons. En arrivant au niveau de la couche 321, les électrons majoritaires vont s'accumuler dans les couches 30 et 163, ce qui stabilisera l'orientation de la couche 163. On peut donc considérer que le polariseur 12 agit par transmission d'électrons polarisés alors que le polariseur 32 agit par réflexion d'électrons polarisés.

Pour l'écriture d'un "1", les rôles des polariseurs sont inversés, mais les effets de stabilisation et d'abaissement de la densité critique demeurent.

Le polariseur 32 élimine le champ de couplage magnéto-statique sur la couche 16 et permet aussi d'avoir une direction d'échange identique entre les couches 121 et 323 afin de rendre possible la mise en ordre magnétique des couches antiferromagnétiques d'échange 10 et 34. Il est en effet difficile de définir deux directions d'échange opposées dans un système utilisant un seul type de matériau antiferromagnétique.

La lecture s'effectue comme dans la première variante en injectant un courant de densité inférieure à la densité critique et en comparant la tension lue à la tension d'une jonction de référence.

Les deux modes de réalisation qui viennent d'être décrits peuvent être comparés dans le tableau ci-dessous, où :

- t est l'épaisseur de la couche magnétique à retourner,
- Ms est l'aimantation à saturation de la couche à retourner, dans le cas de CoFe (Ms=1500 emu/cc)),
- Hk est l'anisotropie de la couche magnétique à retourner,
- Jc (écriture) est la densité de courant pour écrire un point mémoire,
- $RA_{max}$ est le produit de la résistance par la surface de la jonction tunnel, défini de telle façon que la tension à l'écriture n'excède pas 0,6 V,

- Jc (lecture) est la densité de courant pour une tension de lecture de 0,3 V avec RA$_{max}$,
- a$_{min}$ est la taille minimale d'un côté du point mémoire (pour un point mémoire carré) avant d'atteindre la limite superparamagnétique.

La valeur de a$_{min}$ est calculée d'après la formule :

$$a_{min} \simeq \sqrt{\frac{84k_B T}{M_s H_k t}}$$

dans laquelle la valeur 84 est calculée en considérant une durée de fonctionnement de la mémoire de 100 ans à une température de 100°C.

| Mode de réalisation | 1 | 2 |
|---|---|---|
| t(nm) | 5 | 5 |
| Ms (emu/cc) | 1500 | 1500 |
| Hk effectif (G) | 40 | 40 |
| Jc (écriture) (A/cm$^2$) | 3,2E + 05 | 1,6E + 05 |
| RA$_{max}$ (Ohm.$\mu$m$^2$) | 188 | 375 |
| Jc (lecture) (A/cm$^2$) | 1,6E + 05 | 8E + 04 |
| a$_{min}$ (micron) | 0,12 | 0,12 |

On voit, d'après ce tableau, qu'avec l'invention on peut atteindre de faibles densités de courant d'écriture, compatibles avec des jonctions de produit RA raisonnables (>100 $\Omega.\mu$m$^2$). De tels produits RA peuvent être obtenus, soit par oxydation plasma, soit et de préférence par oxydation naturelle in situ.

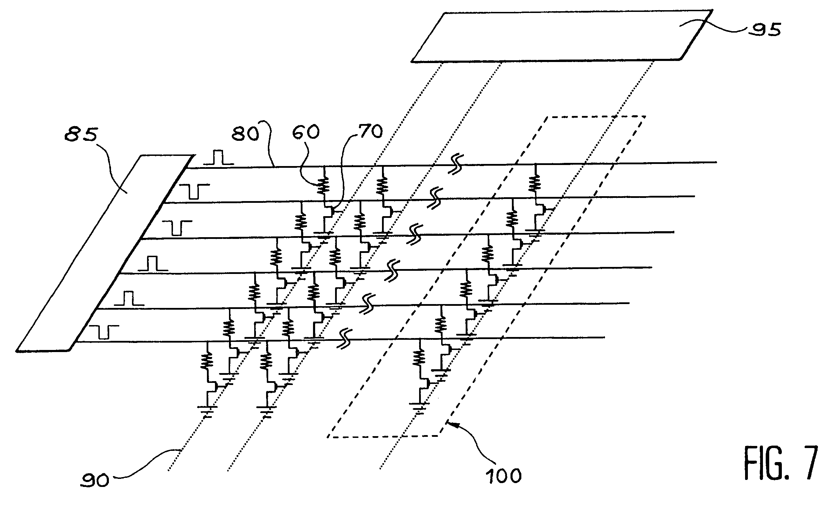

La figure 7, enfin, montre une mémoire formée d'une matrice de points mémoires adressables par lignes et par colonnes. Chaque point mémoire comprend un dispositif conforme à l'invention, avec un empilement de couches symbolisé par une résistance 60 et un moyen de commutation 70 constitué par un transistor. Chaque empilement est relié à une ligne d'adressage 80 et la base (ou la porte) du transistor à une colonne d'adressage 90. Les lignes 80 sont dites "lignes de bit" et les colonnes 90 "lignes de mot" (ou de digit). Les lignes 80 sont reliées aux sorties d'un circuit d'adressage ligne 85 et les colonnes 90 aux sorties d'un circuit d'adressage colonne 95.

Lorsqu'une séquence de bits doit être écrite (par exemple 100110), on commande l'adressage d'une colonne par une impulsion apte à ouvrir les transistors de la colonne en question et l'on envoie sur chaque ligne une impulsion de courant ayant une polarité appropriée (dans l'exemple pris respectivement +--++-). Tous les bits se trouvent ainsi écrits dans la colonne de cette mémoire, simultanément.

Cet adressage multiple est possible grâce à l'invention puisque, comme expliqué dans l'introduction, un point mémoire peut être écrit sans risque d'écriture intempestive sur les points voisins.

Quelque part dans la mémoire, par exemple au centre, se trouve une colonne de référence 100, qui permet la lecture. Lorsqu'un courant de lecture circule dans les points mémoires d'une colonne 90, on compare la tension de lecture de chaque point avec la tension lue sur le point mémoire de la colonne de référence appartenant à la même ligne.

Ce mécanisme d'écriture et de lecture par colonne réduit considérablement le temps de cycle de la mémoire.

## Revendications

1. Dispositif magnétique comprenant :

    • une première couche magnétique dite "piégée" (12) ayant une aimantation de direction fixe,
    • une seconde couche magnétique dite "libre" (16) ayant une aimantation de direction variable,
    • une couche isolante ou semi-conductrice (14) séparant la couche piégée et la couche libre,
    • des moyens (22, 24) pour faire circuler dans les couches et perpendiculairement à celles-ci un courant d'électrons,

    la couche magnétique piégée ou la couche magnétique libre étant apte à polariser le spin de ces électrons,
    la couche magnétique libre (16), au moins, étant formée d'un premier empilement tri-couche constitué par deux couches magnétiques (161, 163) à aimantations antiparallèles séparées par une couche conductrice non magnétique (162),
    **caractérisé en ce que** les moyens (22, 24) pour faire circuler dans les couches et perpendiculairement à celles-ci un courant d'électrons sont des moyens d'écriture faisant un courant d'électrons à travers les couches dans un sens et dans le sens opposé.

2. Dispositif selon la revendication 1, dans lequel ladite couche magnétique piégée (12) est formée d'un deuxième empilement tri-couche constitué par deux couches magnétiques (121, 123) d'aimantations antiparallèles séparées par une couche conductrice non magnétique (122), ce deuxième empilement étant recouvert d'une première couche d'échange antiferromagnétique (10) fixant la direction des aimantations dans ledit deuxième empilement tri-couche (12).

3. Dispositif selon la revendication 2, comprenant en outre un troisième empilement tri-couche formé (32) par deux couches magnétiques (321, 323) à aimantations antiparallèles séparées par une couche conductrice non magnétique (322), ce troisième empilement tri-couche (32) étant séparé du premier (16) par une couche conductrice non magnétique (30), ce troisième empilement tri-couche (32) reposant sur une seconde couche d'échange antiferromagnétique (34) fixant les aimantations dans ledit troisième empilement tri-couche (32).

**4.** Dispositif selon l'une quelconque des revendications 1 à 3, dans lequel les deux couches magnétiques (161, 163) du premier empilement tri-couche (16) ont même épaisseur.

**5.** Dispositif selon l'une quelconque des revendications 1 à 3, dans lequel les couches magnétiques du premier (16) et/ou du deuxième (12) et/ou du troisième (32) empilement tri-couche sont en un matériau pris dans le groupe constitué par Co, Fe, Ni et leurs alliages.

**6.** Dispositif selon l'une quelconque des revendications 1 à 3, dans lequel la couche conductrice non magnétique du premier (162) et/ou du deuxième (122) et/ou du troisième (322) empilement tri-couche est en un métal pris dans le groupe constitué par Ru, Re, Cu, Cr, Pt, Ag.

**7.** Dispositif selon l'une quelconque des revendications 2 et 3, dans lequel la première (10) et/ou la seconde (34) couche antiferromagnétique est en alliage à base de Mn.

**8.** Dispositif selon l'une quelconque des revendications 1 à 7, dans lequel le courant d'électrons a une densité supérieure à une certaine densité critique.

**9.** Dispositif selon la revendication 8, comprenant en outre des moyens de lecture aptes à faire circuler un courant d'électrons à travers les couches avec une densité inférieure à ladite densité critique, et des moyens pour mesurer la tension apparaissant aux bornes de l'empilement de couches.

**10.** Mémoire comprenant une matrice de points mémoire adressables par des lignes (80) et des colonnes d'adressage (90), **caractérisée en ce que** chaque point mémoire est constitué par un dispositif magnétique (60) selon l'une quelconque des revendications 1 à 7, et par un moyen de commutation de courant (70) placé en série avec le dispositif (60), chaque dispositif magnétique (60) étant relié à une ligne d'adressage (80) et chaque moyen de commutation (70) à une colonne d'adressage (90).

**11.** Mémoire selon la revendication 10, comprenant en outre une colonne de référence (100) et des moyens pour comparer la tension lue aux bornes d'un dispositif situé au croisement d'une ligne (80) et d'une colonne (96) déterminées et la tension lue aux bornes du dispositif situé sur la même ligne (80) mais sur la colonne de référence (100).

**Claims**

**1.** Magnetic device consisting of:

• a first magnetic layer called the "anchored" layer (12) which has a fixed magnetisation direction,
• a second magnetic layer called the "free" layer (16) which has a variable magnetisation direction,
• an insulating or semiconducting layer (14) which separates the anchored layer from the free layer,
• means (22, 24) for passing a current of electrons through and perpendicular to the layers,
• the anchored magnetic layer or the free magnetic layer being able to polarize the spin of said electronics,

the free magnetic layer (16), at least, consisting of a first tri-layer stack which consists of two magnetic layers (161, 163) with anti-parallel magnetisation, separated by a conducting non-magnetic layer (162), **characterized in that** the means (22, 24) for passing into the layers and perpendicular thereto an electron current are writing means making an electron current pass through the layers in a first direction and in the opposite direction.

**2.** Device in accordance with claim 1, in which the said anchored magnetic layer (12) consists of a second tri-layer stack which consists of two magnetic layers (121, 123) with anti-parallel magnetisation, separated by a conducting non-magnetic layer (122), this second stack being covered with a first layer of anti-ferromagnetic exchange (10) which fixes the direction of magnetisation in the said second tri-layer stack (12).

**3.** Device in accordance with claim 2, including additionally a third tri-layer stack (32) formed of two magnetic layers (321, 323) with anti-parallel magnetisation, separated by a conducting non-magnetic layer (322), this third stack (32) being separated from the first (16) by a conducting non-magnetic layer (30), this third tri-layer stack (32) being mounted on a second anti-ferromagnetic exchange layer (34) which fixes the magnetisation in the said third tri-layer stack (32).

**4.** Device in accordance with any of claims 1 to 3, in which the two magnetic layers (161, 163), in the first tri-layer stack (16) are of the same thickness.

5. Device in accordance with any of claims 1 to 3, in which the magnetic layers of the first tri-layer stack (16) and/or the second tri-layer stack (12) and/or the third tri-layer stack (32) are made from a material taken from the group formed by Co, Fe, Ni and their alloys.

6. Device in accordance with any of claims 1 to 3, in which the conducting non-magnetic layer of the first tri-layer stack (162), and/or the second tri-layer stack (122) and/or the third tri-layer stack (322) is made from a metal taken from the group formed by Ru, Re, Cu, Cr, Pt, Ag.

7. Device in accordance with either of claims 2 and 3, in which the first anti-ferromagnetic layer (10) and/or the second anti-ferromagnetic layer (34) is made from a Mn-based alloy.

8. Device in accordance with any of claims 1 to 7, wherein the current of electrons has a density greater than a certain critical density.

9. Device in accordance with claim 8, including additionally reading means suitable for passing a current of electrons through the layers, with a density less than the said critical density, and means for measuring the voltage appearing at the terminals of the layer stack terminals.

10. Memory consisting of a matrix of memory cells addressable in rows (80) and columns (90), **characterized in that** each memory cell consists of a magnetic device (60) in accordance with any of claims 1 to 7, and by a current switching means (70) connected in series with the device (60), each magnetic device (60) being connected to an addressing row (80) and each switching means (70) to an addressing column (90).

11. Memory in accordance with claim 10, including additionally a reference column (100) and means for comparing the voltage read at the terminals of a device located at the intersection between a specific row (80) and a column (90), and the voltage read at the terminals of the device located on the same row (80) but in the reference column (100).

**Patentansprüche**

1. Magnetische Vorrichtung, umfassend:

• eine erste, sogenannte "gefangene" magnetische Schicht (12), die eine Magnetisierung mit festgelegter Richtung hat,
• eine zweite, sogenannte "freie" magnetische Schicht (16), die eine Magnetisierung mit variabler Richtung hat,
• eine die gefangene Schicht und die freie Schicht trennende Isolier- oder Halbleiterschicht (14),
• Einrichtungen (22, 24) um in den Schichten und senkrecht zu diesen einen Elektronenstrom fließen zu lassen,

wobei die gefangene magnetische Schicht oder die freie magnetische Schicht fähig ist, den Spin dieser Elektronen zu polarisieren, und wenigstens die freie magnetische Schicht (16) durch einen ersten Dreischichtenstapel gebildet wird, bestehend aus zwei magnetischen Schichten (161, 163) mit antiparallelen Magnetisierungen, getrennt durch eine nichtmagnetische Leiterschicht (162),
**dadurch gekennzeichnet, dass** die Einrichtungen (22, 24), fähig in den Schichten und senkrecht zu diesen einen Elektronenstrom fließen zu lassen, Schreibeinrichtungen sind, die einen Elektronenstrom in einer Richtung und in der entgegengesetzten Richtung durch die Schichten fließen lassen.

2. Vorrichtung nach Anspruch 1, bei der die gefangene magnetische Schicht (12) durch einen zweiten Dreischichtenstapel gebildet wird, bestehend aus zwei magnetischen Schichten (121, 123) mit antiparallelen Magnetisierungen, getrennt durch eine nichtmagnetische Leiterschicht (122), wobei dieser zweite Stapel mit einer ersten antiferromagnetischen Austauschschicht (10) bedeckt ist, welche die Richtung der Magnetisierungen in dem genannten zweiten Dreischichtenstapel (12) festlegt.

3. Vorrichtung nach Anspruch 2, mit außerdem einem dritten Dreischichtenstapel (32), gebildet durch zwei magnetische Schichten (321, 323) mit antiparallelen Magnetisierungen, getrennt durch eine nichtmagnetische Leiterschicht (322), wobei dieser dritte Dreischichtenstapel (32) von dem ersten (16) durch eine nichtmagnetische Leiterschicht (30) getrennt ist, und dieser dritte Dreischichtenstapel (32) auf einer zweiten antiferromagnetischen Austauschschicht (34) ruht, welche die Magnetisierungen in dem genannten dritten Dreischichtenstapel (32) festlegt.

4. Vorrichtung nach einem der Ansprüche 1 bis 3, bei der die beiden magnetischen Schichten (161, 163) des ersten Dreischichtenstapels (16) dieselbe Dicke haben.

5. Vorrichtung nach einem der Ansprüche 1 bis 3, bei der die beiden magnetischen Schichten des ersten (16) und/oder zweiten (12) und/oder dritten (32) Dreischichtenstapels aus einem Material sind, das aus der Gruppe stammt, die durch Co, Fe, Ni und ihren Legierungen gebildet wird.

6. Vorrichtung nach einem der Ansprüche 1 bis 3, bei der die nichtmagnetische Leiterschicht des ersten (162) und/oder zweiten (122) und/oder dritten (322) Dreischichtenstapels aus einem Metall ist, das aus der Gruppe stammt, die gebildet wird durch Ru, Re, Cu, Cr, Pt, Ag.

7. Vorrichtung nach einem der Ansprüche 2 und 3, bei der die erste (10) und/oder zweite (34) antiferromagnetische Schicht aus einer Legierung auf der Basis von Mn ist.

8. Vorrichtung nach einem der Ansprüche 1 bis 7, bei der der Elektronenstrom eine Dichte aufweist, die höher ist als eine bestimmte kritische Dichte.

9. Vorrichtung nach Anspruch 8 mit außerdem Leseeinrichtungen, fähig einen Elektronenstrom durch die Schichten fließen zu lassen, dessen Dichte niedriger ist als die genannte kritische Dichte, und Einrichtungen zum Messen der Spannung an den Anschlüssen des Schichtenstapels.

10. Speicher mit einer Matrix von Speicherpunkten, adressierbar durch Adressierungszeilen (80) und -spalten (90),
**dadurch gekennzeichnet, dass** jeder Speicherpunkt gebildet wird durch eine magnetische Vorrichtung (60) nach einem der Ansprüche 1 bis 7 und durch eine Stromschalteinrichtung (70), in Serie mit der magnetischen Vorrichtung (60) angeordnet, wobei jede magnetische Vorrichtung (60) mit einer Adressierungsleitung (80) und jede Schalteinrichtung (70) mit einer Adressierungsspalte (90) verbunden ist.

11. Speicher nach Anspruch 10 mit außerdem einer Referenzspalte (100) und Einrichtungen zum Vergleichen der an den Anschlüssen der an der Kreuzung einer bestimmten Zeile (80) und einer bestimmten Spalte (90) befindlichen Vorrichtung abgegriffenen Spannung mit der an den Anschlüssen derjenigen magnetischen Vorrichtung abgegriffenen Spannung, die sich in derselben Zeile (80), aber in der Referenzspalte (100) befindet.

FIG.1A

FIG.1B

22

10

121

122

12

123

14

18

161

16

162

163

20

24

FIG. 2

FIG. 4 A

FIG. 4 B

FIG. 5

FIG. 6A

FIG. 6B

FIG. 7

**EP 1 223 585 B1**

**RÉFÉRENCES CITÉES DANS LA DESCRIPTION**

**Documents brevets cités dans la description**

- US 5695864 A
- US 5966323 A
- EP 1187103 A